# EUROPEAN PATENT APPLICATION

(11) **EP 3 587 627 A1**
(43) Date of publication of application: **01.01.2020**
(21) Application number: 18196768.8
(22) Date of filing: 26.09.2018
(51) Int. Cl.: C30B 11/00, C30B 29/42

(54) **SEMICONDUCTOR SYNTHESIZING DEVICE AND METHOD**

(30) Priority: 29.06.2018 CN 201810698427
(71) Applicant: Hanergy New Material Technology Co., Ltd., Yanqi Industrial Development Zone Huairou District Beijing 101407 (CN)
(72) Inventor: Lei, Rengui, Beijing, Beijing 101407 (CN); Xiao, Yadong, Beijing, Beijing 101407 (CN); Tan, Xiaotian, Beijing, Beijing 101407 (CN)
(74) Representative: Cohausz & Florack

(57) **Abstract**

A semiconductor synthesizing device comprises a closed reaction tube (4), a first furnace body (1) and a second furnace body (2). The reaction tube (4) is arranged with a plurality of horizontal boat containers (5, 11, 12) which include a plurality of first-layer horizontal boat containers (11) and a second-layer horizontal boat container (12) superposed on a bracket device (13) provided on at least one of the first-layer horizontal boat containers (11). The bracket device (13) is configured to support the second-layer horizontal boat container (12) and provides a gap between the first-layer horizontal boat container (11) and the second-layer horizontal boat container (12).

## Description

### TECHNICAL FIELD

The present disclosure relates to improvements in semiconductor preparation devices and methods employing the Horizontal Bridgman method (horizontal boat production method).

### BACKGROUND

The Horizontal Bridgman method is a method for preparing large-area shaped flaky crystals developed by Bridgman, also known as the horizontal boat method, referred to as the HB method. The HB method is widely used, especially in the growth of compound semiconductor crystals, and can also be used for doping of semiconductor materials. The HB method is to place a raw material or doping raw material for growing crystals in a vessel to be placed in a circular tube, and close a nozzle of the tube after vacuumizing; the crystal is grown by directional solidification or directional zone melting, or the semiconductor is doped by a suitable semiconductor doping method.

Jin Min et al. introduce horizontal directional solidification for synthesizing gallium arsenide polycrystals (Journal of Shanghai Institute of Technology, September 2014, 187-190), where a furnace consisting of 8 stages of controlled single crystal temperature includes 5 stages of high temperature zone, 1 stage of medium temperature zone, and 2 stages of low temperature zone. Arsenic and gallium are placed in a quartz boat at two ends of a quartz tube, respectively. The quartz tube is welded in a vacuum-sealed manner and then placed in a horizontal directional solidification furnace, where the gallium end is placed in the high temperature zone, and the arsenic end is placed in the low temperature zone. A temperature in the low temperature zone is controlled at around 630 °C, and a temperature in the high temperature zone is controlled at 1250 to 1255 °C. A directional solidification of gallium arsenide polycrystals is achieved by controlling a cooling process of different stages.

CN107268085A discloses a preparation device for doping semi-insulating gallium arsenide polycrystal with carbon, including a cylindrical heating device, wherein one end of the heating device is a source region and the other end is a growth region. A control temperature of the heating device increases from the source region to the growth region. A quartz tube is fixedly disposed in the heating device. A first PBN boat for receiving graphite powders and a second PBN boat for receiving a chloride, fluoride or oxide of Groups III to IV are disposed adjacently at a position in the quartz tube corresponding to the source region, and a third PBN boat for receiving gallium arsenide polycrystals is disposed at a position in the quartz tube corresponding to the growth region. The quartz tube is in a vacuum-sealed state during reaction.

### SUMMARY

A first aspect of the present disclosure provides a semiconductor synthesizing device applied in the Horizontal Bridgman method, including a closed reaction tube, a first furnace body, and a second furnace body, wherein the first furnace body and the second furnace body are connected via an intermediate pipe, the reaction tube is placed in a furnace chamber jointly defined by the first furnace body, the intermediate pipe and the second furnace body, and a temperature control device is provided corresponding to the first furnace body and the second furnace body separately and respectively, wherein the reaction tube is arranged with a plurality of horizontal boat containers which include a plurality of first-layer horizontal boat containers disposed at different positions in the reaction tube in a horizontal direction, and a second-layer horizontal boat container superposed on a bracket device provided on at least one of the first-layer horizontal boat containers, and wherein the bracket device is configured to support the second-layer horizontal boat container and provide a gap between the first-layer horizontal boat containers and the second-layer horizontal boat container.

A second aspect of the present disclosure provides a synthesizing method for gallium arsenide polycrystals using the device of the second aspect of the disclosure, wherein in the superposed horizontal boats, a loading weight of an upper-layer horizontal boat container is smaller than a loading weight of a lower-layer horizontal boat container.

### BRIEF DESCRIPTION OF DRAWINGS

Fig. 1 is a schematic view of a reaction device according to an embodiment of the disclosure;
Fig. 2 is a schematic view of a reaction device according to an embodiment of the disclosure;
Fig. 3 is a schematic view of a reaction device according to an embodiment of the disclosure;
Fig. 4 is a schematic view of a reaction device according to an embodiment of the disclosure;
Fig. 5 is a schematic view of a reaction device according to an embodiment of the disclosure;
Fig. 6 is a schematic view showing a projection of a horizontal boat container used in an embodiment of the disclosure;
Fig. 7 is a schematic view showing a projection of a horizontal boat container used in an embodiment of the disclosure;
Fig. 8 is a schematic view showing a projection of a horizontal boat container used in an embodiment of the disclosure;
Fig. 9 is a cross sectional view showing a horizontal boat container used in an embodiment of the disclosure;
Fig. 10 is a cross sectional view showing a horizontal boat container used in an embodiment of the disclosure;
Fig. 11 is a plan view showing a of a horizontal boat container used in an embodiment of the disclosure;
Fig. 12 is a structural view showing a bracket used in an embodiment of the disclosure;

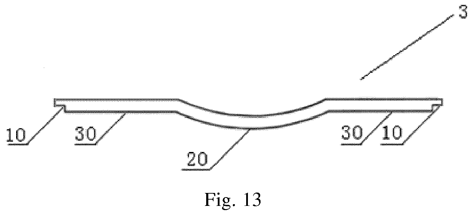

Fig. 13 is a structural view showing a bracket used in an embodiment of the disclosure.

### DETAILED DESCRIPTION

Embodiments of the present disclosure are described below in conjunction with the drawings. Similar reference numerals are used throughout the drawings to describe similar or identical components. The various features disclosed herein may be used alone or in combination with one another, and the disclosure is not limited to the specific combinations described herein. The described embodiments are therefore not intended to limit the scope of the claims.

The phrase "in an embodiment", "in embodiments", "in some embodiments", or "in other embodiments" may be employed in the description, each referring to one or more of the same or different embodiments as disclosed herein.

It should also be noted that, in this context, relational terms such as first and second, are used merely to distinguish one entity or operation from another without necessarily requiring or implying that there is any such actual relationship or order between such entities or operations. Moreover, the term "comprise," "comprising" or any variant thereof means to be non-exclusive so that an item or device including a series of elements includes not only said elements, but also other elements not explicitly listed, or inherent elements of such items or devices. In the absence of more limitations, an element defined by "includes a ..." do not exclude the existence of additional identical elements in the item or device including the element.

At present, the horizontal boat containers are generally arranged at different positions of the closed reaction tube in the horizontal direction, and the arrangement of the horizontal boat containers is further limited due to a limited space within the reaction tube. There is no spatial arrangement in the art for superposing horizontal boats in a reaction tube. In particular, no design for stably superposing the horizontal boats, or technical means for controlling a gap between the superposed horizontal boats, is proposed.

In order to produce a plurality of semiconductor crystal rods simultaneously, the inventor has devised a configuration in which a plurality of horizontal boat containers are superposed to effectively and stably control a gap between the superposed horizontal boat containers. Further, there is still room for improvement in the uniformity quality of the plurality of semiconductor crystal rods produced by superposing a plurality of horizontal boat containers. When the crystal rod is synthesized by the Horizontal Bridgman method, temperatures in the high temperature zone and the low temperature zone are difficult to control due to heat radiation and the like, and the following problems often occur: polycrystalline material oxidation or arsenic leakage caused by, for example, deformation and cracking of the quartz tube; and incomplete synthesis of a polycrystalline material at a tail portion.

In order to solve the above problems, the present disclosure proposes various technical solutions. The various technical solutions are described in detail below by way of embodiments.

### [Embodiment 1]

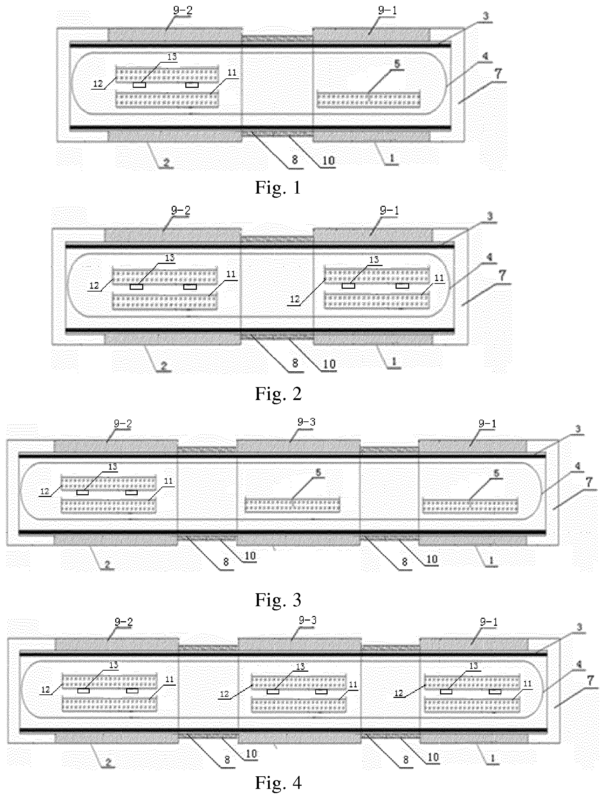

As shown in Fig. 1, Embodiment 1 is a semiconductor synthesizing device applied in a Horizontal Bridgman method, wherein the synthesizing device includes a closed reaction tube 4, a first furnace body 1 and a second furnace body 2. The first furnace body 1 and the second furnace body 2 are connected via an intermediate pipe 8. The reaction tube 4 is placed in a furnace chamber jointly defined by the first furnace body 1, the intermediate pipe 8, and the second furnace body 2. Temperature control devices 9-1, 9-2 are provided corresponding to the first furnace body 1 and the second furnace body 2 separately and respectively.

The temperature control device 9-1 that provides heating below 1000 °C includes a temperature control unit of 2 to 4 stages, and the temperature control device 9-2 that provides heating above 1000 °C includes a temperature control unit of 5 to 7 stages.

The temperature control unit is used to control a temperature of the furnace body, and may include a heating unit and a temperature measuring unit. The heating unit may heat through a high frequency induction coil or a resistance heating furnace, and the temperature measuring unit may perform a measurement through a thermocouple.

A first-layer horizontal boat container 11 is placed at a left side of the closed reaction tube 4 and provided with a bracket device 13 on which a second-layer horizontal boat container 12 is superposed. The bracket device 13 is configured to support the second-layer horizontal boat container 12 and defines a preset gap between the first-layer horizontal boat container 11 and the second-layer horizontal boat container 12 so that a reactant enters or gets out of the superposed horizontal boat containers.

Another horizontal boat container 5 is arranged at a right side of the closed reaction tube 4. It should be understood that the horizontal boat container 5 may also employ the configuration of the first-layer horizontal boat container 11 so as to facilitate manufacture of the components.

In a specific application, the reactant in the horizontal boat sublimates to react with a reactant in another horizontal boat.

### [Embodiment 2]

Embodiment 2 is similar to Embodiment 1 except that four horizontal boat containers are provided in Embodiment 2 and divided into two groups each employing a superposed arrangement.

As shown in Fig. 2, two first-layer horizontal boat containers 11 are arranged at two ends of the closed reaction tube 4 in the horizontal direction, each provided with a bracket device 13 on which a second-layer horizontal boat container 12 is superposed. The bracket device 13 is configured to support the second-layer horizontal boat container 12 and provide a gap between the first-layer horizontal boat container 11 and the second-layer horizontal boat container 12.

### [Embodiment 3]

Similar to Embodiments 1 and 2 and as shown in Fig. 3, in the Embodiment 3, three groups of horizontal boat containers are provided in a horizontal direction of the reaction tube 4. The first group is two superposed horizontal boats, and the first-layer horizontal boat container 11 is provided with a bracket device 13 on which a second-layer horizontal boat container 12 is superposed. The other two groups of horizontal boat containers 5 are disposed at an intermediate position and a right position in the horizontal direction respectively and separately. It should be understood that the horizontal boat containers 5 may also employ the configuration of the first-layer horizontal boat container 11 so as to facilitate manufacture of the components.

### [Embodiment 4]

Embodiment 4 is similar to Embodiments 1, 2 and 3 except that three groups of two-layer superposed horizontal boats are provided. As shown in Fig. 4, in the closed reaction tube 4, three first-layer horizontal boat containers 11 are arranged in the horizontal direction, each provided with a bracket device 13 on which a second-layer horizontal boat container 12 is superposed, wherein the bracket device 13 is configured to support the second-layer horizontal boat container 12 and provide a preset gap between the first-layer horizontal boat container 11 and the second-layer horizontal boat container 12.

### [Embodiment 5]

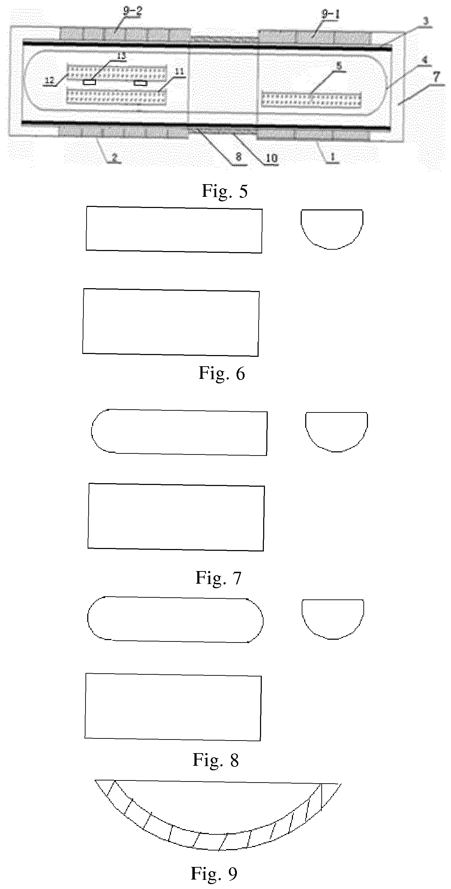

As shown in Fig. 5, the device of Embodiment 5 is used for preparing a gallium arsenide semiconductor by the Horizontal Bridgman method, wherein the synthesizing device includes a closed reaction tube 4, a first furnace body 1 and a second furnace body 2, wherein the first furnace body 1 and the second furnace body 2 are connected via an intermediate pipe 8, the reaction tube 4 is placed in a furnace chamber jointly defined by the first furnace body 1, the intermediate pipe 8, and the second furnace body 2, and temperature control devices 9-1, 9-2 are provided corresponding to the first furnace body 1 and the second furnace body 2 separately and respectively.

The second furnace body 2 is composed of 6 stages of temperature control, and the first furnace body 1 is composed of 3 stages of temperature control.

The temperature control unit is used to control a temperature of the furnace body, and may include a heating unit and a temperature measuring unit. The heating unit may heat through a high frequency induction coil or a resistance heating furnace, and the temperature measuring unit may perform a measurement through a thermocouple.

An arsenic boat 5 and gallium boats 11, 12 sealed by the quartz closed reaction tube 4 are placed in the first furnace body 1 and the second furnace body 2, respectively. The second-layer gallium boat 12 is superposed on the first-layer gallium boat 11 by providing a bracket device 13, and a gap is provided between the first-layer gallium boat 11 and the second-layer gallium boat 12 for the reactant arsenic entering and getting out of the superposed horizontal boat containers. This arrangement makes it possible to produce two gallium arsenide crystal rods at a time by the device of the embodiment. It should be understood that although the arsenic boat 5 and the gallium boat 11 have different reference numerals, the arsenic boat 5 and the gallium boat 11 may adopt a similar structure to facilitate manufacture of the components.

Through different arrangements and combinations, those skilled in the art may place more kinds of reaction products in the tube according to the needs and target products, or cooperate with a more reasonable arrangement and heating control manner.

The device of the present disclosure may simultaneously synthesize a plurality of crystal rods by superposing horizontal boat containers, thereby improving production efficiency and reducing production cost. In order to improve the quality of the synthesized product, the present disclosure further, by adopting a heating structure with double furnaces for heating, conducts temperature control of the low temperature zone and the high temperature zone by a furnace body respectively so that the temperature during synthesis of the semiconductor is easily controlled, thus realizing accurate control of the temperature of the furnace body. As a result, the plurality of semiconductors synthesized at one time (for example, polycrystals or single crystals) have a uniform ratio as well as a high yield.

Further variant embodiments for Embodiments 1 to 5 are as follows.

### [Furnace Body]

Alternatively, an outer periphery of the intermediate pipe 8 is covered by a thermal insulating material 10. Due to the proper thermal insulating measure between the high temperature zone and the low temperature zone, the evaporated components are completely reacted with other components to obtain a semiconductor compound having a uniform ratio and good performance.

Alternatively, an inner sidewall of at least one of the first furnace body 1 and the second furnace body 2 is further provided with a spacing layer 3, so as to define a furnace chamber uniformly heated within a space surrounded by the spacing layer 3. This arrangement may be used to improve uniformity of an internal thermal field, so as to further improve ratio uniformity and yield of the synthesized semiconductor product.

Alternatively, the spacing layer 3 is configured to be selected from the group consisting of a quartz tube, a silicon carbide tube, a mullite tube, and combinations thereof. Silicon carbide tube, mullite tube or combinations thereof is/are preferred, because spacing layers of such configurations are more durable while nonuniformity of an internal temperature in radial direction can be effectively reduced.

Alternatively, when placed in the first furnace body 1 and the second furnace body 2, the closed reaction tube 4 is separated from the inner sidewall by the spacing layer 3. Thus, the uniformity of the internal thermal field is further improved, while the ratio uniformity and yield of the synthesized semiconductor product is further increased.

Alternatively, a distance between the first furnace body 1 and the second furnace body 2 is 15 to 20 cm.

The two furnace bodies are separated by a certain distance to avoid difficulties in temperature control in the low temperature zone due to, for example, thermal diffusion and heat radiation. However, a too large distance, for example, more than 20 cm, will lead to a too cold middle part, while a too small distance, for example, less than 15 cm, is not sufficient for temperature control in the low temperature zone and the high temperature zone. Researchers have found that the above range of distance may realize temperature control in the low temperature zone and the high temperature zone, while a temperature of the middle joint is always maintained within a proper range, so as to ensure a smooth reaction and obtain a semiconductor product with a uniform ratio.

Alternatively, the thermal insulating material 10 covering the outer periphery of the intermediate pipe 8 is a low-density thermal insulating material having a coating thickness of 3 cm to 5 cm. A too thin material cannot perform thermal insulation effectively, while a too thick material is a waste of the raw material. Therefore, the above range may meet the requirements on thermal insulation while minimizing the cost.

The low-density thermal insulating material is a material made from a component containing silica and/or alumina. Thermal insulating material, also known as thermal insulation material, refers to a material or material complex that has significant resistance to heat flow. Common characteristics of thermal insulating materials are light, loose, porous or fibrous, insulating heat conduction with internal stagnant air, wherein inorganic materials have advantages such as being non-combustible, usable in a wide temperature range, and chemically resistant. The thermal insulating material used in the present disclosure is made of, for example, a component containing silica, a component containing alumina, or a component containing silica and alumina. Specific preparation methods and products may refer to methods known in the art, and products prepared according to the methods such as disclosed in CN 101671158A, CN102795781A, and the like.

Alternatively, the preparation device further includes an insulating and sealing material plate 7 at two ends of the first furnace body 1 and the second furnace body 2. The insulating and sealing material plate 7 may be, for example, an insulating cotton plate, a silicic acid fiberboard, or the like. The insulating and sealing materials of the first furnace body and the second furnace body may be the same or different. For example, the thermal insulating material of the first furnace body may be suitable for providing a furnace body of a lower temperature, while the thermal insulating material of the second furnace body may be suitable for providing a furnace body of a higher temperature.

### [Reaction Tube]

The reaction tube used in the embodiments may be a quartz reaction tube having a size generally used in the art, such as an inner diameter of 80 mm. An inner diameter of the horizontal boat container placed therein is adapted to the reaction tube, and may be slightly smaller than the inner diameter of the reaction tube. A depth of the horizontal boat container may be set according to the number of layers placed therein. If two layers are provided, the depth of the horizontal boat container is about 40 mm or less, for example, 20 to 35 mm, specifically 24 mm, 28 mm, 31 mm, 34 mm, or the like.

### [Horizontal Boat]

The HB method is to place a raw material for growing single crystals in a vessel to be placed in a circular tube, and close a nozzle of the tube after vacuumizing. The vessel is generally called a "boat". At present, there are synthesizing boats and pulling boats in view of the use. The synthesizing boat is used for synthesizing polycrystals; while the pulling boat is used for growing single crystals.

An opening of the synthesizing boat may have a rectangular shape, as shown in the projection view of Fig. 5; or may be semicircle at one end, as shown in the projection view of Fig. 6; or may be semicircle at two ends, as shown in the projection view Fig. 7. Semicircular boats have been used for decades, and their greatest feature is easy to machine: breaking a circular tube in half, and then adding a boat head and/or a boat tail. A main body of the synthesizing boat or the pulling boat typically has an arched cross section, as shown in Fig. 8. Apparently, the cross section may also be rectangular, as shown in Fig. 9, or have other shapes used in the art.

In the projection view, the upper left is a plan view, the lower left is a main view, and the upper right is a left view.

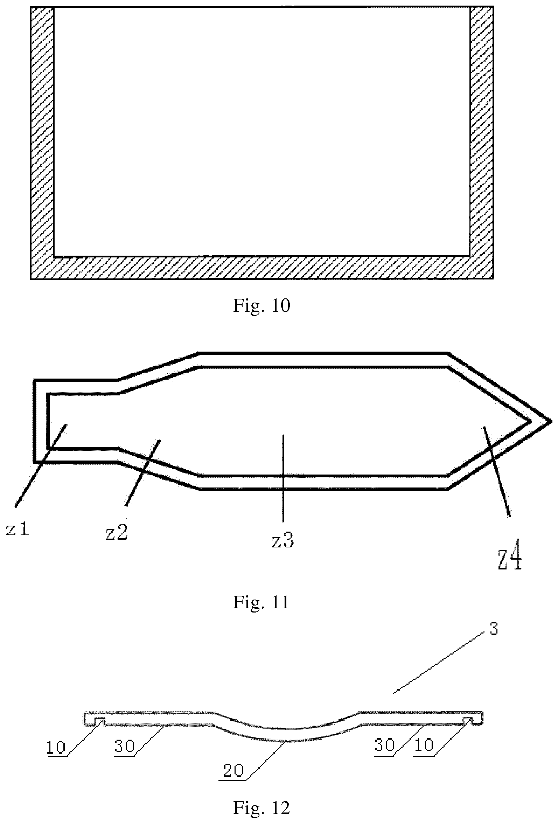

A seed region and a shoulder portion are added into the boat for growing single crystals on the basis of the synthesizing boat for polycrystals. The boat for growing single crystals is composed of a seed cavity at a front extremity, which has various shapes including square, rectangle and semicircle; a shoulder portion located between a main body and the seed cavity, which has a function of joining the seed cavity and the main body smoothly; the main body portion of the boat for growing single crystals in the middle and a boat tail at a distal end. Specifically referring to Fig. 10, zl to z4 show the seed cavity portion, the shoulder portion, an equal diameter portion (i.e., the main body portion) and the boat tail portion in sequence.

### [Bracket Device]

Alternatively, the bracket device 13 may be separately provided. In other words, the bracket device 13 is an independent component from the horizontal boat container. The bracket device 13 may be assembled onto the horizontal boat container to provide support for the horizontal boat container mounted thereon. The bracket device 13 may be mounted to the horizontal boat container after the loading operation (loading raw materials) is finished. Therefore, the separately provided bracket device does not affect the loading operation of the horizontal boat container. Alternatively, the bracket device 13 may be integrated with the horizontal boat container. For example, the bracket device 13 is integrated with an upper portion of the first-layer horizontal boat 11 or a lower portion of the second-layer horizontal boat 12. The integrated arrangement is more convenient to use, and thus is beneficial to realizing industrial production while facilitating structural stability during operation.

Alternatively, the horizontal boat container includes a main body portion disposed substantially at a central portion of the horizontal boat container, the main body portion having a generally U-shaped cross section.

Alternatively, the bracket device 13 is provided as a bridge member, two ends of which are respectively snapped on two sidewalls of the horizontal boat container (for example, the first-layer horizontal boat 11) that are arranged substantially in parallel with an axial direction of the reaction tube 4. With the connection by snapping, it allows easy assembly of the horizontal boat container and bracket device, simplifying assembly steps.

Alternatively, a central portion of the bracket device 13 is provided with a concave arched portion 20 to conform to a shape of a bottom of the second-layer horizontal boat container 12. Specifically, a structural schematic view of the bracket is as shown in Fig. 12. In a plane perpendicular to the axial direction of the reaction tube 4, the central portion of the bracket device 13 is provided with the concave arched portion 20. The arched portion 20 of the bracket device 13 abuts the bottom of the horizontal boat container to provide a stable support for the horizontal boat container. Alternatively, as shown in Figs. 11 and 12, the bracket device 13 further includes a horizontal portion 30 having a thickness of 2 to 3 mm. The arched portion 20 has a thickness of 2.5 to 3.5 mm, which is slightly greater than the thickness of the horizontal portion. For example, the thickness of the arched portion 20 is 0.2 to 0.5 mm greater than the thickness of the horizontal portion 30. Such arrangement is more conducive to stably supporting a boat placed on the upper layer, making the bracket device more durable and facilitating a sufficient and smooth reaction.

Alternatively, an arc length of the arched portion 20 is 1/4 to 1/2, preferably 1/3, of a perimeter (length) of an outer surface of a horizontal boat container placed on the bracket.

Alternatively, the bracket device 13 further includes two recesses 10 for snapping the bracket 3 onto the horizontal boat container 2. The recesses10 may be disposed at a position of the horizontal portion 30 adjacent to an end thereof, as shown in Figs. 11 and 12. By the arrangement of the recesses, the bracket device 13 may be stably engaged with a lower-layer horizontal boat container (for example, the first-layer horizontal boat container 11) to form a stable assembly.

In order to make an upper-layer horizontal container (a container located on an upper side) supported by the bracket more stable, alternatively, a depth of the recess 10 is 1 to 1.5 mm, more advantageously 1.2 to 1.4 mm, most advantageously about 1.3 mm, thus making the snap more stable. The two recesses have the same depth.

Width and thickness of the bracket 13 and sizes related to the recess 10 used in the disclosure may be adjusted according to actual needs. A length of the recess 10 may be set according to a wall thickness of the horizontal boat container as long as it is just snapped with or slightly larger than the wall thickness.

A length of the bracket in the disclosure may be set according to a width of the lower-layer horizontal boat container (a container located on an lower side) spanned by the bracket, and is considered to facilitate better movement of the superposed boat inside the quartz tube. One specific form of the bracket is a bridge bracket.

Alternatively, the number of the bracket devices 13 disposed on one horizontal boat is 1, 2, 3, 4, and the like, and optionally 2 or more, especially 3.

Alternatively, the reaction device of the embodiments is used for semiconductor synthesis or semiconductor doping reactions.

Alternatively, the reaction device is used for synthesizing gallium arsenide polycrystals or single crystals, optionally for synthesizing gallium arsenide polycrystals.

Alternatively, the bracket device is made of a PBN (pyrolysis boron nitride) material or a graphite material with depositing a layer of PBN (pyrolysis boron nitride) material on a surface of the graphite material. It needs to be considered not to introduce impurities during the reaction when selecting the material of the bracket device.

An embodiment of the present disclosure further provides a synthesizing device for gallium arsenide polycrystals, wherein a first furnace body is a low temperature zone furnace body, and a second furnace body is a high temperature zone furnace body, a horizontal boat container containing arsenic and a horizontal boat container containing gallium are respectively placed in the low temperature zone furnace body and the high temperature zone furnace body, and the horizontal boat container containing gallium is superposed (e.g., superposing the second-layer horizontal boat container 12 on the first-layer horizontal boat container 11), so as to provide a plurality of gallium arsenide polycrystalline rods at one preparation process.

An aspect of the present disclosure further provides a synthesizing method for gallium arsenide polycrystals using the synthesizing device for gallium arsenide polycrystals of the disclosure, wherein in the horizontal boats being superposed (superposed horizontal boats), a loading weight of the horizontal boat container located on an upper side (upper-layer horizontal boat container) is smaller than a loading weight of the horizontal boat container located on a lower side (lower-layer horizontal boat container). During reaction, the closed reaction tube is vacuumized or filled with an inert gas for protection.

Alternatively, the loading weight of the lower-layer horizontal boat container is 1 to 1.5 times, more advantageously about 1.3 times, the loading weight of the upper-layer horizontal boat container.

To improve understanding of the technical solution of the present disclosure for those skilled in the art, the synthesis of gallium arsenide polycrystals is taken as an example for illustration.

In order to verify the technical means and efficacy of the present disclosure for achieving the predetermined objects, a production experiment is repeated three times according to the following implementation. The specific implementation process is detailed as follows:
(1) washing a material such as a quartz ampoule, a PBN boat and a PBN bridge with an mixed acid of hydrofluoric acid, nitric acid and deionized water, and dehydrating and drying the material with ethanol for further use;
(2) putting the cleaned PBN boat into a clean quartz furnace for baking at a baking temperature about 600 to 900 °C for 2 to 4 hours, and then naturally cooling to room temperature for further use;
(3) weighing about 2000g of 6N gallium, placing it in a PBN boat and then at an end of an opening of the quartz ampoule, and evenly placing 3 PBN bridges on the boat, and weighing about 1500g of 6N gallium, placing it in another PBN boat and then on the boat with the PBN bridges, and pushing them together onto a bottom of the quartz ampoule at the same time; weighing about 3680g of 6N arsenic in a PBN boat and placing the boat into a cleaned port of the quartz ampoule and finally covering a quartz cap;
(4) transferring the installed quartz ampoule to the furnace, vacuumizing and heating to a temperature of 150 to 300 °C, turning off the power after 3 to 4 hours of heat preservation, welding in a vacuum-sealed manner, and naturally cooling to room temperature;
(5) installing the sealed quartz ampoule with arsenic and gallium into an HB horizontal furnace body, placing an end of the boat with arsenic in a low temperature zone furnace and an end of the boat with gallium in a high temperature zone furnace, and sealing the two ends with a thermal insulating cotton;
(6) heating according to a preset heating procedure with a temperature in the low temperature zone controlled at about 620 to 650 °C and a temperature of the high temperature zone furnace at 1250 to 1255 °C, preserving the temperatures for 1 to 3 hours and cooling to room temperature according to a preset cooling procedure after sufficient reaction;
(7) taking the quartz ampoule out from the furnace body, cutting the quartz tube from the arsenic end, and taking out and testing the synthesized semicircular polycrystalline rod.

A polycrystalline rod obtained by three times of synthesis has a glossy, dense, non-porous, non-gallium-rich surface with a good synthesis ratio; one polycrystalline rod is taken from each furnace to take a piece of head portion and tail portion for testing, and parameters about the yield and electrical properties of the polycrystal obtained by three times of synthesis are specifically shown in Table 1 below.

**Table 1**

| Times of experiments | Yield | Head carrier concentration /cm⁻³ | Tail carrier concentration /cm⁻³ |
|---|---|---|---|
| 1 | 94.1 % | 3.7*10¹⁶ | 2.6*10¹⁶ |
| 2 | 93.5 | 5.5*10¹⁶ | 6.7*10¹⁶ |
| 3 | 94.4 | 4.6*10¹⁶ | 3.8*10¹⁶ |

By the superposed arrangement of the horizontal boat containers, the present disclosure can make a plurality of crystal rods at a time without increasing the volume of the reaction tube, thereby improving production efficiency and reducing cost. At the same time, in cooperation with providing a temperature control device for the first furnace body and the second furnace body respectively and separately, the present disclosure realizes effective and separate control of the temperatures in the high temperature zone and the low temperature zone, reduces influences of undesired heat radiation, and prevents polycrystalline oxidation or arsenic leakage caused by, for example, deformation and cracking of the quartz tube. As can be seen from the data shown in Table 1, the obtained gallium arsenide crystal rob has a uniform ratio and good performance.

The present disclosure proposes a bracket construction that facilitates placement of the upper-layer boat. Based on this, the present disclosure proposes a synthesizing device where the horizontal boat containers are superposed, which is particularly suitable for improving the HB method. The superposed configuration of the plurality of horizontal boat containers of the present disclosure is stable, enables a reaction to be performed smoothly and normally, improves the production efficiency, and reduces cost. More advantageously, the present disclosure may prepare a plurality of crystal rods at a time without increasing the volume of the reaction tube. In addition, applications using a wider variety of chemical reaction components may be improved.

To further optimize quality of the crystal rods prepared by a multilayer horizontal boat container, the present disclosure, by providing a temperature control device for the first furnace body and the second furnace body respectively and separately, realizes effective and separate control of the temperatures in the high temperature zone and the low temperature zone, reduces influences of undesired heat radiation, and prevents polycrystalline oxidation or arsenic leakage caused by, for example, deformation and cracking of the quartz tube, thus obtaining a plurality of semiconductor compound crystal rods with a uniform ratio and good performance.

In addition, the device provided by the present disclosure may further improve semiconductor synthesis and semiconductor doping processes. The present disclosure provides a design for superposing horizontal boat containers in a closed reaction tube, and in particular provides a unique design for providing a first-layer horizontal boat container with a bracket device on which a second-layer horizontal boat container is superposed, in cooperation with relatively independent control of temperatures in a high temperature zone and a low temperature zone. Compared to traditional designs, it is conducive to the development of new semiconductor preparation processes, new semiconductor synthesis methods, and new semiconductor products.

The present disclosure includes at least the following concepts:
Concept 1. A semiconductor synthesizing device applied in the Horizontal Bridgman method, comprising a closed reaction tube, a first furnace body, and a second furnace body,
   wherein the first furnace body and the second furnace body are connected via an intermediate pipe, the reaction tube is placed in a furnace chamber jointly defined by the first furnace body, the intermediate pipe and the second furnace body, and temperature control devices are provided corresponding to the first furnace body and the second furnace body separately and respectively,
   wherein the reaction tube is arranged with a plurality of horizontal boat containers which include a plurality of first-layer horizontal boat containers disposed at different positions in the reaction tube in a horizontal direction, and a second-layer horizontal boat container superposed on a bracket device provided on at least one of the first-layer horizontal boat containers, and wherein the bracket device is configured to support the second-layer horizontal boat container and provide a gap between the first-layer horizontal boat containers and the second-layer horizontal boat container.
Concept 2. The semiconductor synthesizing device according to Concept 1, wherein an outer periphery of the intermediate pipe is covered by a thermal insulating material.
Concept 3. The semiconductor synthesizing device according to Concept 1 or 2, wherein an inner sidewall of at least one of the first furnace body and the second furnace body is further provided with a spacing layer to define a furnace chamber uniformly heated within a space surrounded by the spacing layer.
Concept 4. The semiconductor synthesizing device according to Concept 3, wherein the spacing layer is configured to be selected from the group consisting of a quartz tube, a silicon carbide tube, a mullite tube, and combinations thereof.
Concept 5. The semiconductor synthesizing device according to Concept 3, wherein when placed in the first furnace body and the second furnace body, the closed reaction tube is separated from the inner sidewall by the spacing layer.
Concept 6. The semiconductor synthesizing device according to any one of Concepts 1 to 5, wherein the temperature control device includes a first temperature control device corresponding to the first furnace body, having a temperature control unit of 2 to 4 stages to provide heating below 1000 °C, and a second temperature control device corresponding to the second furnace body, having a temperature control unit of 5 to 7 stages to provide heating above 1000 °C.
Concept 7. The semiconductor synthesizing device according to any one of Concepts 1 to 6, wherein a distance between the first furnace body and the second furnace body is 15 to 20 cm.
Concept 8. The semiconductor synthesizing device according to any one of Concepts 2 to 7, wherein the thermal insulating material covering the outer periphery of the intermediate pipe is a low-density thermal insulating material having a coating thickness of 3 cm to 5 cm.
Concept 9. The semiconductor synthesizing device according to any one of Concepts 1 to 8, wherein the bracket device is separately provided.
Concept 10. The semiconductor synthesizing device according to any one of Concepts 1 to 8, wherein the bracket device is integrated with the horizontal boat container.
Concept 11. The semiconductor synthesizing device according to Concept 10, wherein the bracket device is integrated with an upper portion of the first-layer horizontal boat container or a lower portion of the second-layer horizontal boat container.
Concept 12. The semiconductor synthesizing device according to any one of Concepts 1 to 11, wherein the horizontal boat container includes a main body portion disposed substantially at a central portion of the horizontal boat container, the main body portion having a generally U-shaped cross section.
Concept 13. The semiconductor synthesizing device according to any one of Concepts 1 to 12, wherein the bracket device is a bridge member, two ends of which are respectively snapped on two sidewalls of the horizontal boat container that are arranged substantially in parallel with an axial direction of the reaction tube.
Concept 14. The semiconductor synthesizing device according to Concept 13, wherein a central portion of the bracket device is provided with a concave arched portion to conform to a shape of a bottom of the second horizontal boat container.
Concept 15. The semiconductor synthesizing device according to Concept 14, wherein an arc length of the arched portion is 1/4 to 1/2, preferably 1/3, of a perimeter of an outer surface of a horizontal boat container placed on the bracket.
Concept 16. The semiconductor synthesizing device according to any one of Concepts 1 to 15, wherein the bracket further includes two recesses for snapping the bracket onto the horizontal boat container.
Concept 17. The semiconductor synthesizing device according to any one of Concepts 1 to 16, wherein the number of the bracket devices is two or more.
Concept 18. The semiconductor synthesizing device according to any one of Concepts 1 to 17, wherein the bracket device is made of a PBN material or a graphite material with depositing a layer of PBN material on a surface of the graphite material.
Concept 19. The semiconductor synthesizing device according to any one of Concepts 1 to 18, wherein the device is used for semiconductor synthesis or semiconductor doping.
Concept 20. The semiconductor synthesizing device according to Concept 19, wherein the reaction device is used for gallium arsenide polycrystalline synthesis or gallium arsenide single crystal synthesis.
Concept 21. A synthesizing device for gallium arsenide polycrystals, comprising the semiconductor synthesizing device according to any one of Concepts 1 to 20, the first furnace body is a low temperature zone furnace body, and the second furnace body is a high temperature zone furnace body, a horizontal boat container containing arsenic and a horizontal boat container containing gallium are respectively placed in the low temperature zone furnace body and the high temperature zone furnace body, and the horizontal boat container containing gallium is superposed, so as to prepare a plurality of gallium arsenide polycrystalline rods at one preparation process.
Concept 22. The synthesizing device according to Concept 21, wherein the high temperature zone furnace body is composed of 6 stages of temperature control, and the low temperature zone furnace body is composed of 3 stages of temperature control.
Concept 23. A synthesizing method for gallium arsenide polycrystals using the device according to Concept 21 or 22, wherein in the superposed horizontal boats, a loading weight of an upper-layer horizontal boat container is smaller than a loading weight of a lower-layer horizontal boat container.

## Claims

1. A semiconductor synthesizing device applied in the Horizontal Bridgman method, comprising a closed reaction tube (4), a first furnace body (1), and a second furnace body (2),
wherein the first furnace body (1) and the second furnace body (2) are connected via an intermediate pipe (8), the reaction tube (4) is placed in a furnace chamber jointly defined by the first furnace body (1), the intermediate pipe (8) and the second furnace body (2), and a temperature control device (9-1, 9-2) is provided corresponding to the first furnace body and the second furnace body separately and respectively,
wherein the reaction tube (4) is arranged with a plurality of horizontal boat containers (5, 11, 12) which include a plurality of first-layer horizontal boat containers (11) disposed at different positions in the reaction tube in a horizontal direction, and a second-layer horizontal boat container (12) superposed on a bracket device (13) provided on at least one of the first-layer horizontal boat containers (11) and wherein the bracket device (3) is configured to support the second-layer horizontal boat container (12) and provide a gap between the first-layer horizontal boat containers (11) and the second-layer horizontal boat container (12).

2. The semiconductor synthesizing device according to claim 1, wherein an outer periphery of the intermediate pipe (8) is covered by a thermal insulating material (10), the thermal insulating material (10) is a low-density thermal insulating material having a coating thickness of 3 cm to 5 cm.

3. The semiconductor synthesizing device according to claim 1 or 2, wherein an inner sidewall of at least one of the first furnace body (1) and the second furnace body (2) is further provided with a spacing layer (3) to define a furnace chamber uniformly heated within a space surrounded by the spacing layer (3).

4. The semiconductor synthesizing device according to claim 3, wherein the spacing layer (3) is configured to be selected from the group consisting of a quartz tube, a silicon carbide tube, a mullite tube, and combinations thereof.

5. The semiconductor synthesizing device according to claim 3, wherein when placed in the first furnace body (1) and the second furnace body (2), the closed reaction tube (4) is separated from the inner sidewall by the spacing layer (3).

6. The semiconductor synthesizing device according to any one of claims 1 to 5, wherein the temperature control device (9-1, 9-2) includes a first temperature control device corresponding to the first furnace body (1), having a temperature control unit of 2 to 4 stages to provide heating below 1000 °C, and a second temperature control device corresponding to the second furnace body (2), having a temperature control unit of 5 to 7 stages to provide heating above 1000 °C.

7. The semiconductor synthesizing device according to any one of claims 1 to 6, wherein a distance between the first furnace body (1) and the second furnace body (2) is 15 to 20 cm.

8. The semiconductor synthesizing device according to any one of claims 1 to 7, wherein the bracket device (13) is integrated with an upper portion of the first-layer horizontal boat container (11) or a lower portion of the second-layer horizontal boat container (12).

9. The semiconductor synthesizing device according to any one of claims 1 to 8, wherein the horizontal boat container (5, 11, 12) includes a main body portion disposed substantially at a central portion of the horizontal boat container (5, 11, 12), the main body portion having a generally U-shaped cross section.

10. The semiconductor synthesizing device according to any one of claims 1 to 9, wherein the bracket device (13) is a bridge member, two ends of the bridge member are respectively snapped on two sidewalls of the horizontal boat container (5, 11, 12) that are arranged substantially in parallel with an axial direction of the reaction tube (4).

11. The semiconductor synthesizing device according to claim 10, wherein a central portion of the bracket device (13) is provided with a concave arched portion (20) to conform to a shape of a bottom of the second horizontal boat container (12).

12. The semiconductor synthesizing device according to claim 11, wherein an arc length of the arched portion (20) is 1/4 to 1/2 of a perimeter of an outer surface of a horizontal boat container (5, 11, 12) placed on the bracket (13).

13. The semiconductor synthesizing device according to any one of claims 1 to 12, wherein the bracket (13) further includes two recesses (10) for snapping the bracket (13) onto the horizontal boat container (5, 11, 12).

14. The semiconductor synthesizing device according to any one of claims 1 to 13, wherein the semiconductor synthesizing device is used for synthesizing gallium arsenide polycrystals, the first furnace body (1) is a low temperature zone furnace body, and the second furnace body (2) is a high temperature zone furnace body, a horizontal boat container containing arsenic and a horizontal boat container containing gallium are respectively placed in the low temperature zone furnace body and the high temperature zone furnace body, and the horizontal boat container containing gallium is superposed, so as to prepare a plurality of gallium arsenide polycrystalline rods at one preparation process, and
wherein the high temperature zone furnace body is composed of 6 stages of temperature control, and the low temperature zone furnace body is composed of 3 stages of temperature control.

15. A synthesizing method for gallium arsenide polycrystals using a semiconductor synthesizing device according to claim 14, wherein in the horizontal boats being superposed, a loading weight of the horizontal boat container located on an upper side is smaller than a loading weight of the horizontal boat container located on a lower side.
